# EUROPÄISCHE PATENTSCHRIFT

(11) **EP 0 945 804 B1**
(45) Veröffentlichungstag und Bekanntmachung des Hinweises auf die Patenterteilung: **21.05.2003**
(21) Anmeldenummer: 99104181.5
(22) Anmeldetag: 02.03.1999
(51) Int. Cl.: G06F 11/22, G11C 29/00, G01R 31/3185

(54) **Integrierte Schaltung und Verfahren zu ihrer Prüfung**
Integrated circuit and method for its testing
Circuit intégré et son procédé de test

(30) Priorität: 02.03.1998 DE 19808664
(43) Veröffentlichungstag der Anmeldung: 29.09.1999
(73) Patentinhaber: Infineon Technologies AG, 81669 München (DE)
(72) Erfinder: Schöniger, Sabine, 81737 München (DE); Schrögmeier, Peter, 81547 München (DE); Hein, Thomas, 81541 München (DE); Dietrich, Stefan Dr., 82299 Türkenfeld (DE)
(74) Vertreter: Müller - Hoffmann & Partner

(56) Entgegenhaltungen:
- US-A- 5 371 390

## Beschreibung

Die Erfindung betrifft eine integrierte Schaltung und ein Verfahren zum Prüfen der integrierten Schaltung über auf einer Hauptfläche der Schaltung angeordnete Kontaktflächen.

Integrierte Schaltungen werden auf aus Halbleitermaterial bestehenden Scheiben, sogenannten Wafern, hergestellt. Jeder Wafer weist eine unter Umständen sehr große Anzahl von einander benachbarten integrierten Schaltungen auf, die so angeordnet sind, daß die Fläche des Wafers möglichst gut ausgenutzt wird. Die Hauptflächen der integrierten Schaltungen sind für gewöhnlich rechteckig. An der Oberfläche jeder integrierten Schaltung befinden sich Kontaktflächen, über die Signale von und zur integrierten Schaltung übertragen werden können. Die Kontaktflächen werden auch als Pads bezeichnet.

Um die auf dem Wafer befindlichen integrierten Schaltungen zu prüfen, werden ihre Kontaktflächen üblicherweise mit Prüfspitzen (das sind Prüfkontakte in Form von Nadeln) eines Prüfgerätes kontaktiert. Anschließend werden über die Prüfspitzen und die mit ihnen kontaktierten Kontaktflächen Signale vom Prüfgerät zur integrierten Schaltung und umgekehrt übertragen.

Viele integrierte Schaltungen weisen Kontaktflächen nur entlang von zwei sich gegenüberliegenden Seiten ihrer Hauptfläche auf. Sind zwei dieser integrierten Schaltungen nebeneinander auf einem Wafer angeordnet, können alle ihre Kontaktflächen problemlos gleichzeitig mit Prüfspitzen kontaktiert werden. Es gibt allerdings auch integrierte Schaltungen, die an mehr als zwei Seiten ihrer Hauptfläche Kontaktflächen aufweisen. Um eine solche Schaltung prüfen zu können, müssen Prüfspitzen von allen vier Seiten mit den entsprechenden Kontaktflächen kontaktiert werden. Sind zwei derartige Schaltungen einander auf dem Wafer benachbart, lassen sich ihre Kontaktflächen nicht ohne weiteres gleichzeitig mit Prüfspitzen kontaktieren, da es dann vor allem an den einander benachbarten Seiten der beiden Schaltungen zu einer Überkreuzung der Prüfspitzen kommen kann. Daher werden benachbarte Schaltungen mit Kontaktflächen an vier Seiten in der Regel nacheinander kontaktiert und geprüft. Daraus ergibt sich eine Verlängerung der für die Prüfung mehrerer benachbarter Schaltungen benötigten Zeit gegenüber dem Fall eines gleichzeitigen Prüfens der Schaltungen.

Aus der US-A-5,371,390 ist eine integrierte Schaltung bekannt, bei der zwei verschiedene Testbetriebsarten durch Kontaktgabe über eine erste und eine zweite Kontaktfläche zu einer ersten bzw. zweiten Teilschaltung möglich ist, wobei in der ersten Testbetriebsart die erste Kontaktfläche der ersten Teilschaltung und die zweite Kontaktfläche der zweiten Teilschaltung zugeordnet sind, während in der zweiten Betriebsart die zweite Kontaktfläche zur Datenübertragung von und/oder zu der ersten Teilschaltung dient.

Der Erfindung liegt die Aufgabe zugrunde, eine integrierte Schaltung anzugeben, bei der das Prüfen über ihre Kontaktflächen mittels Prüfkontakten erleichert ist.

Diese Aufgabe wird mit einer integrierten Schaltung gemäß Anspruch 1 und einem Prüfverfahren gemäß Anspruch 7 gelöst. Vorteilhafte Ausführungen und Weiterbildungen der Erfindung sind Gegenstand von abhängigen Ansprüchen.

Die erfindungsgemäße integrierte Schaltung weist wenigstens eine erste und eine zweite Kontaktfläche zur Datenübertragung von und/oder zu einer ersten bzw. einer zweiten Teilschaltung in einer ersten Betriebsart der Schaltung auf, wobei in einer zweiten Betriebsart der Schaltung die zweite Kontaktfläche zur Datenübertragung von und/oder zu der ersten Teilschaltung dient.

In der zweiten Betriebsart dienen die zweiten Kontaktflächen also zum Übertragen von in der ersten Betriebsart über die entsprechenden ersten Kontaktflächen zu übertragenden Signale. Das bedeutet, daß die von der ersten Kontaktfläche in der ersten Betriebsart ausgeübte Funktion in der zweiten Betriebsart von der zweiten Kontaktfläche übernommen wird. Die entsprechenden Signale werden der Schaltung in der zweiten Betriebsart also an einer anderen Stelle (nämlich die der zweiten Kontaktfläche) zugeführt bzw. entnommen, als in der ersten Betriebsart. Hierdurch können diese Signale in der zweiten Betriebsart problemlos übertragen werden, wenn die erste Kontaktfläche nur schlecht mit Prüfkontakten eines Prüfgerätes kontaktierbar ist, die zweite Kontaktfläche dagegen gut.

Die erfindungsgemäße Schaltung ist dazu geeignet, daß in der zweiten Betriebsart nur die zweiten Kontaktflächen, nicht jedoch die ersten Kontaktflächen mit Prüfspitzen kontaktiert werden, so daß die in der ersten Betriebsart durch die ersten Kontaktflächen ausgeübten Funktionen dann über die zweiten Kontaktflächen geprüft werden können. Hierdurch wird insbesondere das gleichzeitige Prüfen von auf einem Wafer benachbarten Schaltungen erleichtert, bei denen die ersten Kontaktflächen an einander zugewandten Seiten der Schaltungen angeordnet sind, wo sie nur schwer gleichzeitig mit Prüfkontakten zu kontaktieren sind.

In der zweiten Betriebsart kann die zweite Kontaktfläche zum einen ausschließlich der Übertragung von Signalen dienen, die in der ersten Betriebsart über die ersten Kontaktflächen übertragen werden. Über die zweite Kontaktfläche werden dann nicht die in der ersten Betriebsart über sie zu übertragenden Signale übertragen. Dies ist beispielsweise möglich, wenn die zweite Betriebsart eine Testbetriebsart der Schaltung ist, in der eine geringere Anzahl von Kontaktflächen benötigt wird, als in der ersten Betriebsart, weil nur bestimmte Funktionen der Schaltung geprüft werden.

In der zweiten Betriebsart kann die zweite Kontaktfläche zum anderen neben der Übertragung der in der ersten Betriebsart über die erste Kontaktfläche zu übertragenden Signale auch weiterhin der Übertragung der Signale dienen, die sie auch in der ersten Betriebsart überträgt. Dies ist beispielsweise dadurch realisierbar, daß die zweite Kontaktfläche in der zweiten Betriebsart im Zeitmultiplex zur Übertragung der verschiedenen Signalarten dient.

Nach einer Weiterbildung der Erfindung sind die ersten und die entsprechenden zweiten Kontaktflächen in jeweils unterschiedlichen Reihen von Kontaktflächen angeordnet sind, wobei diese Reihen jeweils parallel zu verschiedenen Seiten einer Hauptfläche der Schaltung angeordnet sind.

Es werden dann in der zweiten Betriebsart Engpässe beim Kontaktieren der Schaltung mit Prüfspitzen an der Seite mit den ersten Kontaktflächen durch Verlagerung ihrer Funktion zu den zweiten Kontaktflächen umgangen. Bei zwei auf einem Wafer unmittelbar benachbarten Schaltungen stellen z.B. die einander zugewandten Seiten derartige Engpässe dar, da dort ohne die Erfindung Prüfspitzen auf beiden Schaltungen in unmittelbarer Nähe voneinander kontaktiert werden müssen, so daß die Gefahr des Überkreuzens der Prüfkontakte in diesem Bereich besonders groß ist. Die Erfindung ermöglicht es, daß an der für das Heranführen der Prüfkontakte kritischsten Stelle (das ist diejenige, an der die beiden Schaltungen einander zugewandt sind) durch Verwendung von weniger Prüfkontakten, als Kontaktflächen vorhanden sind, Platz gewonnen wird, so daß eine Kontaktierung der übrigen Kontaktflächen leichter möglich ist.

Wenn die ersten Kontaktflächen an wenigstens einer von zwei sich gegenüberliegenden Seiten der Hauptfläche angeordnet sind und die entsprechenden zweiten Kontaktflächen an wenigstens einer von zwei anderen, sich ebenfalls gegenüberliegenden Seiten, werden Kontaktierungsengpässe an den erstgenannten beiden Seiten in der zweiten Betriebsart umgangen. Daher wird vorteilhaft das gleichzeitige Kontaktieren und Prüfen wenigstens dreier benachbarter Schaltungen erleichtert, die so angeordnet sind, daß die ersten Kontaktflächen jeweils an der der benachbarten Schaltung zugewandten Seite angeordnet sind. An diesen Seiten müssen in der zweiten Betriebsart weniger Kontaktflächen kontaktiert werden, als vorhanden sind. Dagegen können diejenigen Seiten, an denen sich die zweiten Kontaktflächen befinden, problemlos ohne Überkreuzen der Prüfspitzen kontaktiert werden, da an diesen Seiten keine gleichzeitig zu kontaktierenden, benachbarten Schaltungen angeordnet sind. Natürlich können auch mehr als drei der erfindungsgemäßen Schaltungen einander bezüglich ihrer die ersten Kontaktflächen aufweisenden Seiten benachbart sein und gleichzeitig geprüft werden.

Nach einer Weiterbildung ist die integrierte Schaltung eine integrierte Speicherschaltung, bei der wenigstens eine der ersten Kontaktflächen eine Adreß-Kontaktfläche ist, die in der ersten Betriebsart dazu dient, ein Adreßsignal zur Schaltung zu übertragen, und bei der die entsprechende zweite Kontaktfläche in der zweiten Betriebsart dazu dient, das Adreßsignal zu übertragen. Das Adreßsignal dient einer Adressierung von Speicherzellen der Speicherschaltung.

Speziell für Dynamische Speicher (DRAMs) gibt es eine JEDEC-Norm, die das Einleiten von Testbetriebsarten (Test Mode Entry) unter Verwendung sämtlicher Adreßanschlüsse vorsieht. Will man die dort vorgesehenen Funktionen sowohl in der ersten als auch in der zweiten Betriebsart erfüllen, muß also die Funktion sämtlicher Adreß-Kontaktflächen auch in der zweiten Betriebsart verfügbar sein. Dies läßt sich mit der Erfindung erreichen, indem in der zweiten Betriebsart in der beschriebenen Weise die Funktion der ersten Kontaktfläche zur zweiten Kontaktfläche verlagert wird. Bei dieser Speicherschaltung ist also ein JEDEC-Test Mode Entry und eine vollständige Adressierbarkeit ihrer Speicherzellen auch in der zweiten Betriebsart gewährleistet, wenn statt der ersten Kontaktflächen die zweiten Kontaktflächen kontaktiert werden.

Günstig ist es dann, wenn die zweite Kontaktfläche eine Daten-Kontaktfläche ist, die in der ersten Betriebsart dazu dient, in der Schaltung gespeicherte und/oder zu speichernde Daten zu übertragen. Diese Weiterbildung eignet sich z.B. für eine Speicherschaltung, deren zweite Betriebsart eine Testbetriebsart ist, in der alle auch in der ersten Betriebsart benötigten externen Adreßsignale, jedoch nicht alle in der ersten Betriebsart verwendeten Daten-Kontaktflächen benötigt werden.

Die Funktion der zweiten Kontaktfläche als Daten-Kontaktfläche ist in der zweiten Betriebsart beispielsweise dann entbehrlich, wenn die Übertragung der entsprechenden Daten durch einen auf der Schaltung (u.U. nur teilweise) durchgeführten Selbsttest entfällt. Bei einer Art von Selbsttest werden z.B. benötigte Testdaten auf der Speicherschaltung generiert, in die Speicherzellen geschrieben, wieder aus diesen ausgelesen und innerhalb der Speicherschaltung mit den eingeschriebenen Sollwerten verglichen. Nach außerhalb der Schaltung wird über eine der Kontaktflächen nach Abschluß des Selbsttests im Extremfall nur ein einziges Ergebnissignal übermittelt, das das Bestehen oder Nichtbestehen des Tests anzeigt (pass/fail signal). Wird hierfür eine Daten-Kontaktfläche benutzt, stehen alle somit nicht benötigten weiteren Daten-Kontaktflächen in der Testbetriebsart als potentielle zweite Kontaktflächen im Sinne der Erfindung zur Verfügung. Diese können zum Ersetzen von entsprechenden ersten Kontaktflächen vorgesehen sein.

Die Testdaten können in der zweiten Betriebsart z.B. auch in anderer komprimierter Form aus der Speicherschaltung ausgelesen und/oder in diese eingeschrieben werden, wobei auf der Speicherschaltung eine teilweise Auswertung der ausgelesenen Speicherzelleninhalte erfolgt und nur das Ergebnis dieser Auswertung über die Kontaktflächen nach außen übermittelt wird. Auch dies läßt sich mit einer relativ geringen Zahl von Datenanschlüssen bewerkstelligen, so daß in der zweiten Betriebsart nicht alle Daten-Kontaktflächen benötigt werden und sie daher ebenfalls als zweite Kontaktflächen vorgesehen sein können.

Nach einer Weiterbildung weist die integrierte Schaltung eine dritte Kontaktfläche zum Anlegen eines Steuersignals auf, in Abhängigkeit dessen die Schaltung von der ersten in die zweite Betriebsart versetzt wird. Das Steuersignal ermöglicht die von extern über die dritte Kontaktfläche gesteuerte Verlagerung der Funktion der ersten auf die zweiten Kontaktflächen, so daß anschließend der Betrieb in der zweiten Betriebsart ohne Kontaktierung der ersten Kontaktflächen aufgenommen werden kann.

Da die zweite Betriebsart der Erleichterung der Kontaktierung der Schaltung durch Prüfkontakte eines Prüfgerätes dient, ist sie bei einem vereinzelten, nicht mehr auf dem Wafer befindlichen IC entbehrlich. Insbesondere kann vorgesehen sein, bei einem gehäusten IC die dritte Kontaktfläche nicht mit einem exklusiv hierfür vorhandenen Gehäuseanschluß (Pin) zu verbinden. Dann wird sie lediglich als Testkontaktfläche während der an die Herstellung der Schaltung anschließenden Testphase des ungehäusten ICs genutzt und es ist kein zusätzlicher Gehäuseanschluß notwendig. Stattdessen können herkömmliche Gehäuse verwendet werden.

Das erfindungsgemäße Prüfverfahren ist insbesondere auf die erfindungsgemäße integrierte Schaltung anwendbar. Es sieht in der zweiten Betriebsart folgende Schritte vor:
- die zweiten Kontaktflächen werden mit Prüfkcntakten eines Prüfgerätes kontaktiert,
- über die zweiten Kontaktflächen werden Signale übertragen, die in der ersten Betriebsart der Schaltung über die entsprechenden ersten Kontaktflächen übertragen werden.

In der zweiten Betriebsart müssen die ersten Kontaktflächen vorteilhafterweise nicht mit Prüfkontakten kontaktiert werden, da ihre Funktion von den zweiten Kontaktflächen übernommen wird. Die Lage der zweiten Kontaktfläche kann nun so gewählt sein, daß ihre Kontaktierung einfacher durchführbar ist als eine Kontaktierung der ersten Kontaktfläche. Dies ist insbesondere von Vorteil beim Testen benachbarter integrierter Schaltungen auf einem Wafer, deren erste Kontaktflächen so angeordnet sind, daß ihre gleichzeitige Kontaktierung mit Prüfkontakten nur sehr schwer möglich ist. Das erfindungsgemäße Prüfverfahren erleichtert ein gleichzeitiges Testen derartiger benachbarter Schaltungen. Hierdurch müssen benachbarte Schaltungen nicht nacheinander getestet werden, so daß sich die für die Prüfung aller Schaltungen benötigte Zeit reduziert.

Die Erfindung wird im folgenden anhand von in den Figuren dargestellten Ausführungsbeispielen näher erläutert. Es zeigen:
- Figur 1: eine erfindungsgemäße integrierte Schaltung in der Draufsicht mit der Signalbelegung ihrer Kontaktflächen in einer Normalbetriebsart,
- Figur 2: die Schaltung aus Figur 1 mit der Signalbelegung ihrer Kontaktflächen in einer Testbetriebsart,
- Figur 3: ein Detail der integrierten Schaltung aus Figur 1,
- Figur 4: ein Ausführungsbeispiel des erfindungsgemäßen Prüfverfahrens anhand zweier auf einem Wafer benachbarter integrierter Schaltungen nach Figur 1 und
- Figur 5: eine zu Figur 1 alternative integrierte Schaltung mit einer anderen Anordnung ihrer Kontaktflächen.

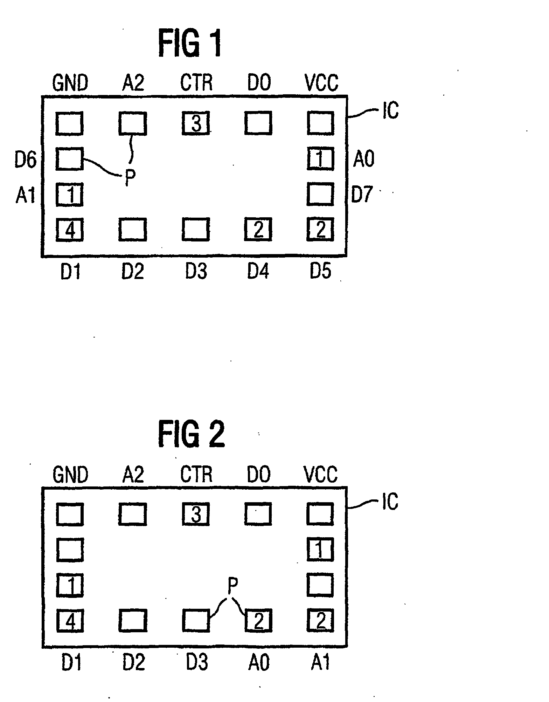

Figur 1 zeigt in einer Draufsicht auf eine ihrer Hauptflächen eine integrierte Speicherschaltung IC mit entlang von vier Seiten ihrer Hauptfläche angeordneten Kontaktflächen P. Die Speicherschaltung IC ist ein DRAM, die Erfindung ist jedoch auch auf andere Schaltungen, insbesondere andere Speicherschaltungen, anwendbar. Die Kontaktflächen P dienen in einer Normalbetriebsart (erste Betriebsart) der Übertragung von Signalen, die in Figur 1 eingetragen sind. Beispielhaft sind zwei Versorgungspotentiale VCC, GND, drei Adreßsignale bzw. Adreßbits A0..A2 und acht Datensignale bzw. Datenbits D0..D7 eingezeichnet. Es sind nur einige für das Verständnis der Erfindung wesentliche Kontaktflächen mit ihrer Signalbelegung dargestellt. Über die Adreßsignale A0..A2 erfolgt eine Adressierung von in der Speicherschaltung enthaltenen Speicherzellen, in die anschließend die Datenbits D0..D7 eingelesen oder aus diese ausgelesen werden können.

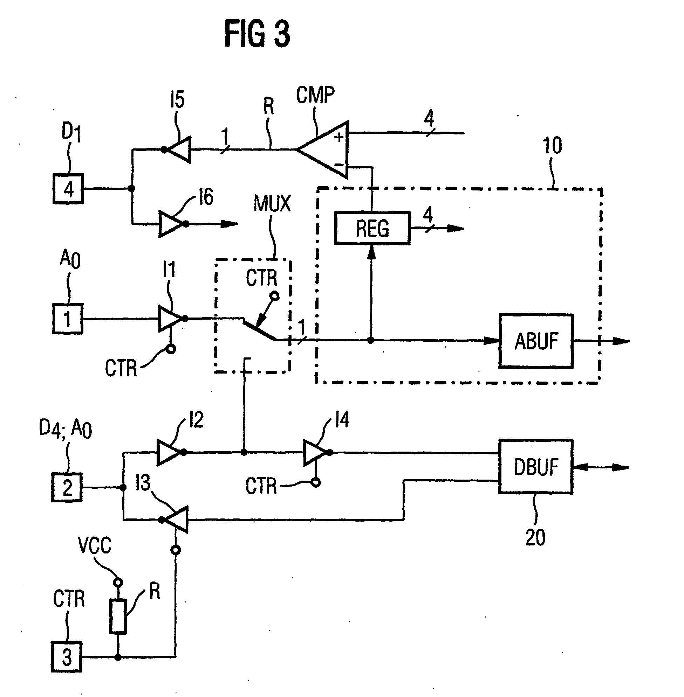

In der Normalbetriebsart sind zwei der Adreßsignale A0, A1 ersten Kontaktflächen 1 an der rechten bzw. linken Seite der Hauptfläche zugeordnet, während zwei der Datenbits D4, D5 zweiten Kontaktflächen 2 an der unteren Seite der Hauptfläche zugeordnet sind. Außerdem ist in der Mitte der oberen Seite der Hauptfläche eine dritte Kontaktfläche 3 angeordnet, die zum Anlegen eines Steuersignals CTR dient, auf das weiter unten anhand Figur 3 noch näher eingegangen wird und in dessen Abhängigkeit die Schaltung IC von der Normal- in eine Testbetriebsart wechselt.

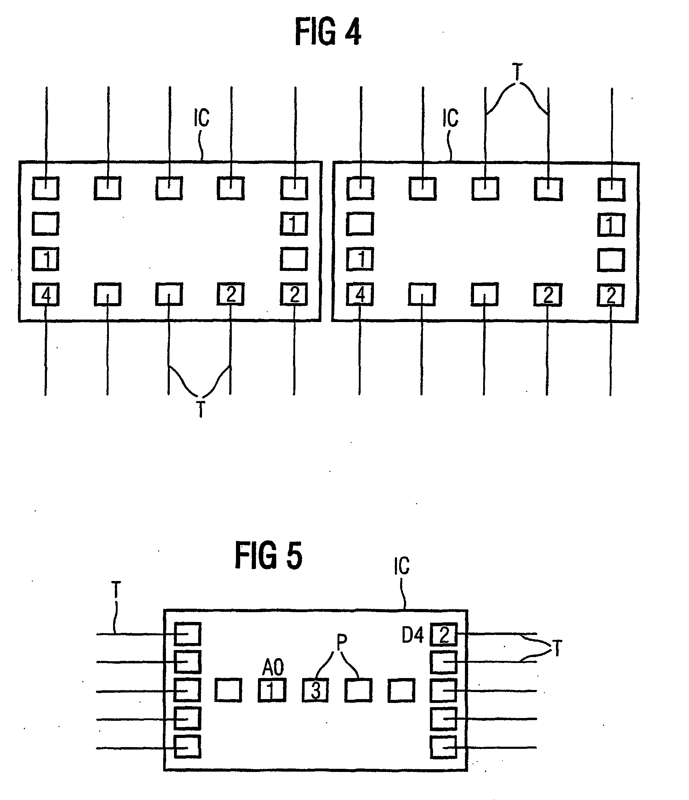

Figur 2 zeigt die Signalbelegung der Kontaktflächen der integrierten Schaltung IC aus Figur 1 während der Testbetriebsart (zweite Betriebsart). Die in der Normalbetriebsart über die ersten Kontaktflächen 1 übertragenen Adreßsignale A0, A1 werden nun über die zweiten Kontaktflächen 2 übertragen, die in der Normalbetriebsart der Übertragung der Datenbits D4, D5 dienen. Somit stehen sowohl in der Normalbetriebsart als auch in der Testbetriebsart Kontaktflächen für alle drei Adreßsignale A0 bis A2 zur Verfügung. Dagegen stehen in der Testbetriebsart lediglich vier Kontaktflächen für eine Übertragung von Datenbits D0..D3 zur Verfügung. Denn auch die beiden Kontaktflächen für die Datenbits D6, D7 an der linken bzw. rechten Seite des ICs stehen in der Testbetriebsart nicht zur Verfügung. In der Testbetriebsart soll nämlich das IC allein durch Kontaktierung der Kontatktflächen an ihrer oberen und unteren Seite geprüft werden, wie dies in Figur 4 dargestellt ist, auf die weiter unten noch eingegangen wird. Die Anzahl der für die Datenübertragung verfügbaren Kontaktflächen variiert also in den beiden Betriebsarten, während die Anzahl der Adreß-Kontaktflächen konstant bleibt.

Da die Anzahl der Adreß-Kontaktflächen in der Testbetriebsart mit derjenigen in der Normalbetriebsart übereinstimmt, ist eine uneingeschränkte Adressierung der Speicherzellen der Speicherschaltung IC in beiden Betriebsarten möglich. Um trotz der Halbierung der Anzahl der Daten-Kontaktflächen in der Testbetriebsart gegenüber der Normalbetriebsart einen Speichertest durchführen zu können, erfolgt in der Testbetriebsart eine Komprimierung der von und zum Speicher IC zu übertragenden Daten. Dies wird im folgenden anhand Figur 3 im Zusammenhang mit dem Wechsel zwischen den beiden Betriebsarten erläutert.

Figur 3 zeigt ein Detail der integrierten Speicherschaltung IC aus Figur 1. Dargestellt ist eine der ersten Kontaktflächen 1, die in der Normalbetriebsart dem Anlegen des Adreßsignals bzw. Adreßbits A0 dient, und die ihr zugeordnete zweite Kontaktfläche 2, die in der Normalbetriebsart der Übertragung des Datenbits D4 dient. Letztere übernimmt in der Testbetriebsart die Funktion der ersten Kontaktfläche 1 und dient dann dem Anlegen des Adreßsignals A0. Weiterhin ist die dritte Kontaktfläche 3 zum Anlegen des die Betriebsart bestimmenden Steuersignals CTR dargestellt sowie eine vierte Kontaktfläche 4, die in den Figuren 1 und 2 links unten auf der Schaltung IC angeordnet ist und zur Ausgabe eines komprimierten Ergebnissignals während des Prüfens des Speichers IC dient.

Die erste Kontaktfläche 1 ist über einen ersten Treiber I1 sowie einen Multiplexer MUX mit einem Adreßregister ABUF verbunden, in dem ein in der Normalbetriebsart an der ersten Kontaktfläche 1 anliegendes Adreßbit A0 gespeichert wird. Ein Ausgang des Adreßregisters ABUF ist mit nicht dargestellten, weiteren Komponenten der Schaltung IC verbunden.

Die zweite Kontaktfläche 2 ist über einen zweiten Treiber I2 und einen diesem nachgeschalteten vierten Treiber I4 sowie einen zu beiden gegenparallel geschalteten dritten Treiber I3 mit einem Datenregister DBUF verbunden, in dem an der zweiten Kontaktfläche 2 in der Normalbetriebsart anliegende Daten, die in (nicht dargestellten) Speicherzellen der Schaltung IC eingeschrieben werden sollen, oder aus den Speicherzellen auszulesende Daten vor der Ausgabe an die zweite Kontaktfläche zwischengespeichert werden. Beim Einschreiben in den Speicher IC ist lediglich der Zweig mit dem zweiten Treiber I2 und dem vierten Treiber I4 und beim Auslesen aus dem Speicher lediglich der Zweig mit dem dritten Treiber 13 aktiv. Hierfür notwendige Schalter bzw. Aktivierungssignale sind in Figur 3 nicht dargestellt.

Im folgenden wird auf den Wechsel zwischen den beiden Betriebsarten eingegangen:

Die dritte Kontaktfläche 3 wird in der Normalbetriebsart mit keinem Signal beaufschlagt. Ein mit ihr verbundener Pull-up Widerstand R sorgt dafür, daß sie dann ein hohes Potential VCC aufweist. Dies hat den Vorteil, daß nur in der Testbetriebsart ein Signal an die dritte Kontaktfläche 3 angelegt werden muß, um ihr Potential auf einen niedrigen Pegel (Masse) zu bringen. Ist beispielsweise zu einem Zeitpunkt, in dem die integrierte Schaltung mit einem Gehäuse versehen wird, die Funktion der Testbetriebsart nicht mehr erwünscht, ist es nicht notwendig, zum permanenten Einstellen der Normalbetriebsart die dritte Kontaktfläche nachträglich mit einem festen Potential zu verbinden. Hierdurch werden zusätzliche Arbeitsschritte vermieden.

Die dritte Kontaktfläche 3 ist mit Aktivierungseingängen des ersten Treibers I1, des dritten Treibers I3, des vierten Treibers I4 und des Multiplexers MUX verbunden. Wird von extern kein Potential an der dritten Kontaktfläche angelegt, sind die genannten Treiber aktiviert und der Multiplexer MUX verbindet den Ausgang des ersten Treibers I1 mit dem Eingang des Adreßregisters ABUF. In der Testbetriebsart wird dagegen an die dritte Kontaktfläche 3 das Steuersignal CTR mit einem niedrigen Pegel (Masse) angelegt, wodurch die genannten Treiber I1, I3, I4 deaktiviert werden. Es können dann keine Daten von der ersten Kontaktfläche 1 über den ersten Treiber I1 in das Adreßregister ABUF oder von der zweiten Kontaktfläche 2 über den vierten Treiber I4 in das Datenregister DBUF eingelesen werden. Außerdem können dann keine Daten über den dritten Treiber I3 aus dem Datenregister DBUF zur zweiten Kontaktfläche 2 ausgelesen werden. Außerdem wird beim niedrigen Pegel des Steuersignals CTR der Multiplexer MUX so geschaltet, daß er den Ausgang des zweiten Treibers I2 mit dem Eingang des Adreßregisters ABUF verbindet. Folglich kann in der Testbetriebsart das Adreßsignal A0 über die zweite Kontaktfläche 2 in das Adreßregister ABUF eingelesen werden, während die erste Kontaktfläche 1 ohne Funktion ist, d.h. über letztere werden dann keine Signale übertragen.

Der Speicher IC enthält für jede der ersten Kontaktflächen 1 und ihre zugehörige zweite Kontaktfläche 2 eine entsprechende Schaltung. Daher stehen in beiden Betriebsarten vier Kontaktflächen zur Übertragung von Adreßsignalen A0..A3 zur Verfügung. Dies ermöglicht vorteilhafterweise auch in der Testbetriebsart eine Aktivierung unterschiedlicher Betriebsmodi durch Anlegen bestimmter Adreßsignale an den Speicher IC, wie dies gemäß der JEDEC-Norm für DRAMs vorgesehen ist ("JEDEC-Test Mode Entry").

Beim in Figur 3 dargestellten Ausführungsbeispiel dient die zweite Kontaktfläche 2 nur in der Normalbetriebsart und nicht auch in der Testbetriebsart einer Übertragung eines Datensignals D4. Nachfolgend wird erläutert, wie trotzdem ein Prüfen des Speichers IC mit Hilfe einer Datenkomprimierung durchgeführt wird:

Der Multiplexer MUX in Figur 3 ist mit dem Eingang eines Register REG verbunden, in das in der Testbetriebsart an der zweiten Kontaktfläche 2 anliegende Testdaten in Form von vier Bits eingeschrieben werden. Hierzu kann es vorgesehen sein, über die zweite Kontaktfläche 2 jeweils nacheinander die vier Bits in das Register REG zu übertragen. Alternativ ist es aber auch möglich, über die zweite Kontaktfläche 2 und drei weitere (nicht dargestellte) Anschlüsse, die ebenso wie die dargestellte zweite Kontaktfläche mit entsprechenden Multiplexern versehen sind, die vier Bits gleichzeitig parallel in das Register REG einzuschreiben.

Nach dem Einschreiben in das Register REG wird sein Inhalt gleichzeitig in vier Speicherzellen eingeschrieben, anschließend gleichzeitig aus diesen wieder ausgelesen und einem Komparator CMP zugeführt, der die ausgelesenen Daten mit dem Inhalt des Registers REG überprüft. Der Komparator CMP übermittelt eine entsprechendes Ergebnissignal R über einen fünften Treiber I5 an die vierte Kontaktfläche 4, die auch in der Normalbetriebsart der Übertragung eines Datensignals D1 dient. Auf die beschriebene Weise können die für die Prüfung des Speichers IC benötigten Daten in komprimierter Weise von und nach außerhalb des Speichers übertragen werden, so daß die geringere Zahl von Daten-Kontaktflächen in der Testbetriebsart ausreicht, ein Prüfen des Speichers IC durchzuführen.

Figur 4 zeigt zwei auf einem Wafer benachbart angeordnete integrierte Schaltungen IC, die beide wie die in Figur 1 und 2 dargestellte Schaltung IC gestaltet sind. Dargestellt ist das erfindungsgemäße Prüfverfahren, bei dem die Schaltungen IC in die Prüfbetriebsart versetzt werden und damit die in Figur 2 gezeigte Signalbelegung ihrer Kontaktflächen P aufweisen. Gezeigt sind die Enden von Prüfkontakten T in Form von Prüfspitzen eines nicht dargestellten Prüfgerätes, mit denen die jeweils an der unteren und oberen Seite der Hauptflächen der Schaltungen IC angeordneten Kontaktflächen P kontaktiert sind, so daß Signale zwischen dem Prüfgerät und den Schaltungen IC übertragen werden können. Dadurch, daß keine der ausschließlich an die jeweils linke und rechte Seite der Hauptflächen angrenzenden Kontaktflächen P in der Testbetriebsart für eine Signalübertragung benötigt werden, kann das Prüfen beider Schaltungen IC allein über die in Figur 4 eingezeichneten Prüfkontakte T erfolgen. Figur 4 ist entnehmbar, daß die Kontaktflächen P ohne ein Überkreuzen der Prüfkontakte T kontaktierbar sind, so daß auch eine weitaus größere Anzahl von links und rechts der dargestellten Schaltungen IC angeordneten, gleichartigen Schaltungen gleichzeitig prüfbar sind.

Dadurch, daß in der zweiten Betriebsart alle ersten Kontaktflächen durch zweite Kontaktflächen ersetzt sind, können in beiden Betriebsarten alle Adreßsignale der Schaltung IC zugeführt werden, obwohl nicht alle Kontaktflächen der Schaltung mit Prüfspitzen kontaktiert werden. In der zweiten Betriebsart reichen weniger Daten-Kontaktflächen aus, um die Schaltung zu prüfen. Dies wird durch die anhand Figur 3 erläuterte Datenkomprimierung beim Einschreiben von Testdaten und Auslesen von Ergebnissignalen für gleichzeitig vier ausgelesene Testbits erreicht.

Figur 5 zeigt ein anderes Ausführungsbeispiel einer integrierten Schaltung IC, bei der die ersten 1 und zweiten 2 Kontaktflächen in Reihen von Kontaktflächen angeordnet sind, die eine andere gegenseitige Anordnung als diejenigen der Schaltung in den Figuren 1, 2 und 4 aufweisen. Die Kontaktflächen sind zum einen entlang einer Reihe angeordnet, die in der gezeigten Draufsicht mittig auf der Chipoberfläche und parallel zur oberen bzw. unteren Kante des Chips angeordnet sind. Diese Reihe enthält eine der ersten Kontaktflächen 1. Der Chip IC weist zwei weitere Reihen von Kontaktflächen auf, die jeweils links und rechts am Rand der Hauptfläche des Chips und parallel zu seinen Seitenkanten angeordnet sind. Die rechte Reihe von Kontaktflächen enthält die der ersten Kontaktfläche 1 zugeordnete zweite Kontaktfläche 2.

In Figur 5 sind auch wieder die Prüfspitzen T eingezeichnet, die in der Testbetriebsart nur die beiden zueinander parallelen Reihen von Kontaktflächen kontaktieren. Die Funktion der ersten Kontaktfläche 1 wird in der Testbetriebsart wieder durch die ihr zugeordneten zweiten Kontaktfläche 2 übernommen. Analog zu Figur 4 ist es problemlos möglich, eine größere Anzahl derartiger Chips IC gleichzeitig mit Prüfspitzen T zu kontaktieren und zu prüfen, sofern sie an den in Figur 5 oben- und untenliegenden Seiten bzw. Kanten der Hauptfläche des dargestellten Chips benachbart angeordnet sind. Die Prüfspitzen T müssen dann wieder nur von rechts und links, nicht aber gleichzeitig von oben und unten an die Chips IC herangeführt werden.

## Patentansprüche

1. Integrierte Schaltung (IC)
- mit wenigstens einer ersten Kontaktfläche (1) zur Datenübertragung von und/oder zu einer ersten Teilschaltung (10) und einer zweiten Kontaktfläche (2) zur Datenübertragung von und/oder zu einer zweiten Teilschaltung (20) in jeweils einer Normalbetriebsart der integrierten Schaltung (IC),
- wobei in einer Testbetriebsart der integrierten Schaltung (IC) die zweite Kontaktfläche (2) Daten von und/oder zu der ersten Teilschaltung (10) überträgt.

2. Integrierte Schaltung nach Anspruch 1, bei der die ersten (1) und die entsprechenden zweiten (2) Kontaktflächen in jeweils unterschiedlichen Reihen von Kontaktflächen (P) angeordnet sind, die jeweils parallel zu verschiedenen Seiten einer Hauptfläche der Schaltung (1) angeordnet sind.

3. Integrierte Schaltung nach Anspruch 2,
bei der die ersten Kontaktflächen (1) an wenigstens einer von zwei sich gegenüberliegenden Seiten der Hauptfläche angeordnet sind und die zweiten Kontaktflächen (2) an wenigstens einer von zwei anderen, sich ebenfalls gegenüberliegenden Seiten.

4. Integrierte Schaltung nach einem der vorstehenden Ansprüche,
- die eine Speicherschaltung ist, bei der wenigstens eine der ersten Kontaktflächen (1) in der ersten Betriebsart dazu dient, ein Adreßsignal (A0) zur Adressierung der Speicherschaltung zu übertragen,
- und bei der die entsprechende zweite Kontaktfläche (2) in der zweiten Betriebsart dazu dient, das Adreßsignal (A0) zu übertragen.

5. Integrierte Schaltung nach Anspruch 4, bei der die zweite Kontaktfläche (2) in der ersten Betriebsart dazu dient, in der Schaltung (IC) gespeicherte und/oder zu speichernde Daten (D4) zu übertragen.

6. Integrierte Schaltung nach einem der vorstehenden Ansprüche, mit einer dritten Kontaktfläche (3) zum Anlegen eines Steuersignals (CTR), in Abhängigkeit dessen die Schaltung (IC) in die zweite Betriebsart wechselt.

7. Verfahren zum Prüfen einer integrierten Schaltung (IC) in einer Testbetriebsart, wobei die Schaltung auf einer Hauptfläche wenigstens eine erste Kontaktfläche (1) und eine zweite Kontaktfläche (2) zu ihrer externen Kontaktierung aufweist,
- bei dem die zweiten Kontaktflächen (2) mit Prüfkontakten (T) eines Prüfgerätes kontaktiert werden,
- und bei dem über die zweiten Kontaktflächen (2) Signale (A0) übertragen werden, die in einer Normalbetriebsart der Schaltung über die entsprechenden ersten Kontaktflächen (1) übertragen werden.

8. Verfahren nach Anspruch 7,
das zum Prüfen einer Schaltung (IC) angewendet wird, bei der die ersten (1) und die entsprechenden zweiten (2) Kontaktflächen in jeweils unterschiedlichen Reihen von Kontaktflächen (P) angeordnet sind, die jeweils parallel zu verschiedenen Seiten der Hauptfläche angeordnet sind.

9. Verfahren nach Anspruch 8,
das zum Prüfen einer integrierten Schaltung (IC) angewendet wird, bei der die ersten Kontaktflächen (1) an wenigstens einer von zwei sich gegenüberliegenden Seiten der Hauptfläche angeordnet sind und die zweiten Kontaktflächen (2) an wenigstens einer von zwei anderen, sich ebenfalls gegenüberliegenden Seiten.

10. Verfahren nach Anspruch 8 oder 9,
bei dem die integrierte Schaltung (IC) sowie eine weitere integrierte Schaltung (IC), die an einer derjenigen Seiten der Hauptfläche der ersten Schaltung angeordnet ist, die wenigstens eine der ersten Kontaktflächen (1) aufweist, gleichzeitig mit Prüfkontakten (T) kontaktiert und geprüft werden.

## Claims

1. Integrated circuit (IC)
- having at least one first contact area (1) for data transfer from and/or to a first subcircuit (10) and a second contact area (2) for data transfer from and/or to a second subcircuit (20) in a respective normal operating mode of the integrated circuit (IC),
- in which case, in a test operating mode of the integrated circuit (IC), the second contact area (2) transfers data from and/or to the first subcircuit (10).

2. Integrated circuit according to Claim 1,
in which the first (1) and the corresponding second (2) contact areas are arranged in respectively different rows of contact areas (P) which are respectively arranged parallel to different sides of a main area of the circuit (1).

3. Integrated circuit according to Claim 2,
in which the first contact areas (1) are arranged on at least one of two opposite sides of the main area and the second contact areas (2) are arranged on at least one of two other, likewise opposite sides.

4. Integrated circuit according to one of the preceding claims,
- which is a memory circuit in which at least one of the first contact areas (1) serves, in the first operating mode, to transfer an address signal (A0) for addressing the memory circuit,
- and in which the corresponding second contact area (2) serves, in the second operating mode, to transfer the address signal (A0).

5. Integrated circuit according to Claim 4,
in which the second contact area (2) serves, in the first operating mode, to transfer data (D4) which are stored and/or are to be stored in the circuit (IC).

6. Integrated circuit according to one of the preceding claims,
having a third contact area (3) for the application of a control signal (CTR), the circuit (IC) changing over to the second operating mode as a function of said control signal.

7. Method for testing an integrated circuit (IC) in a test operating mode, the circuit having, on a main area, at least one first contact area (1) and one second contact area (2) for its external contact-connection,
- in which the second contact areas (2) are contact-connected to test contacts (T) of a test apparatus,
- and in which signals (A0) which are transferred via the corresponding first contact areas (1) in a normal operating mode of the circuit are transferred via the second contact areas (2).

8. Method according to Claim 7,
which is used to test a circuit (IC) in which the first (1) and the corresponding second (2) contact areas are arranged in respectively different rows of contact areas (P) which are each arranged parallel to different sides of the main area.

9. Method according to Claim 8,
which is used to test an integrated circuit (IC) in which the first contact areas (1) are arranged on at least one of two opposite sides of the main area and the second contact areas (2) are arranged on at least one of two other, likewise opposite sides.

10. Method according to Claim 8 or 9,
in which the integrated circuit (IC) and also a further integrated circuit (IC) arranged on one of those sides of the main area of the first circuit which has at least one of the first contact areas (1) are simultaneously contact-connected to test contacts (T) and tested.

## Revendications

1. Circuit (IC) intégré
- comprenant au moins une première surface (3) de contact pour la transmission de données en provenance d'un premier sous-circuit (10) et/ou à celui-ci et une deuxième surface (2) de contact pour la transmission de données en provenance d'un deuxième sous-circuit (20) et/ou à celui-ci dans respectivement un type normal de fonctionnement du circuit (IC) intégré,
- dans lequel dans un type de fonctionnement d'essai du circuit (IC) intégré, la deuxième surface (2) de contact transmet des données en provenance du premier sous-circuit (10) et/ou à celui-ci.

2. Circuit intégré suivant la revendication 1, dans lequel les premières surfaces (1) de contact et les deuxièmes surfaces (2) de contact correspondantes sont disposées dans respectivement des rangées différentes de surfaces (P) de contact qui sont respectivement parallèles à des côtés différents d'une surface principale du circuit (1).

3. Circuit intégré suivant la revendication 2, dans lequel les premières surfaces (1) de contact sont disposées au moins sur l'un de deux côtés opposés de la surface principale et les deuxièmes surfaces (2) de contact sont disposées sur au moins l'un de deux autres côtés également opposés.

4. Circuit intégré suivant l'une des revendications précédentes,
- qui est un circuit de mémoire dans lequel au moins l'une des premières surfaces (1) de contact sert dans le premier type de fonctionnement à transmettre un signal (A0) d'adresse pour l'adressage du circuit de mémoire,
- et dans lequel la deuxième surface (2) de contact correspondante sert dans le deuxième type de fonctionnement à transmettre le signal (A0) d'adresse.

5. Circuit intégré suivant la revendication 4, dans lequel la deuxième surface (2) de contact sert dans le premier type de fonctionnement à transmettre des données (D4) mémorisées dans le circuit (IC) et/ou à mémoriser dans le circuit (IC).

6. Circuit intégré suivant l'une des revendications précédentes,
comprenant une troisième surface (3) de contact pour appliquer un signal (CTR) de commande en fonction duquel le circuit (IC) passe dans le deuxième type de fonctionnement.

7. Procédé de test d'un circuit (IC) intégré dans un type de fonctionnement de test, le circuit ayant sur une surface principale au moins une première surface (1) de contact et une deuxième surface (2) de contact pour sa mise en contact avec l'extérieur,
- dans lequel on met les deuxièmes surfaces (2) de contact en contact avec des contacts (T) d'essai d'un appareil d'essai,
- et dans lequel on transmet par les deuxièmes surfaces (2) de contact des signaux (A0) qui sont transmis dans un type de fonctionnement normal du circuit par les premières surfaces (1) de contact correspondantes.

8. Procédé suivant la revendication 7, utilisé pour tester un circuit (IC), dans lequel les premières surfaces (1) et les deuxièmes surfaces (2) de contact correspondantes sont disposées respectivement dans des rangées différentes de surfaces de contact qui sont respectivement parallèles à des côtés différents de la surface principale.

9. Procédé suivant la revendication 8, utilisé pour tester un circuit (IC) intégré, dans lequel les premières surfaces (1) de contact sont disposées sur au moins l'un de deux côtés opposés de la surface principale et les deuxièmes surfaces (2) de contact sont disposées sur au moins l'un de deux autres côtés également opposés.

10. Procédé suivant la revendication 8 ou 9, dans lequel le circuit (IC) intégré ainsi qu'un autre circuit (IC) intégré qui est disposé sur l'un des côtés de la surface principale du premier circuit qui a au moins l'une des premières surfaces (1) de contact est mis en contact et est testé simultanément par des contacts (T) d'essai.
